# EUROPEAN PATENT APPLICATION

(11) **EP 1 650 769 A1**
(43) Date of publication of application: **26.04.2006**
(21) Application number: 04770947.2
(22) Date of filing: 26.07.2004
(51) Int. Cl.: H01B 3/12, H01L 21/316, C01G 29/00

(54) **LIQUID COMPOSITION FOR FERROELECTRIC THIN FILM FORMATION AND PROCESS FOR PRODUCING FERROELECTRIC THIN FILM**

(30) Priority: 28.07.2003 JP 2003280901
(71) Applicant: ASAHI GLASS COMPANY LTD., Tokyo 100-8405 (JP)
(72) Inventor: SUNAHARA, K., c/o Asahi Glass Company, Ltd., Yokohama-shi, Kanagawa 221-8755 (JP); TOMONAGA, H., c/o Asahi Glass Company, Ltd., Yokohama-shi, Kanagawa 221-8755 (JP); BEPPU, Y., c/o Asahi Glass Company, Ltd., Yokohama-shi, Kanagawa 221-8755 (JP)
(74) Representative: Müller-Boré & Partner Patentanwälte
(86) International application number: PCT/JP2004/010636
(87) International publication number: WO 2005/010895

(57) **Abstract**

The present invention provides a liquid composition for forming a thin film, with which a ferroelectric thin film having excellent characteristics can be prepared even by baking at a low temperature, and a process for producing a ferroelectric thin film using it. A liquid composition for forming a ferroelectric thin film is used, which is **characterized by** comprising a liquid medium, crystalline ferroelectric oxide particles represented by the formula (Bi₂O₂)²⁺ (Biₘ₋₁TiₘO_{3.5m-0.5})²⁻ (wherein m is an integer of from 1 to 5) or (Bi₂O₂)²⁺ (Aₘ₋₁TiₘO_{3.5m-0.5})²⁻ (wherein A is Bi³⁺ or La³⁺, the La³⁺/Bi³⁺ ratio is from 0.05 to 0.5, and m is an integer of from 1 to 5) and having an average primary particle diameter of at most 100 nm, dispersed in the liquid medium, and a soluble metal compound capable of forming a ferroelectric oxide by heating, dissolved in the liquid medium.

## Description

### TECHNICAL FIELD

The present invention relates to a liquid composition for forming a ferroelectric thin film and a process for producing a ferroelectric thin film using it.

### BACKGROUND ART

A ferroelectric random access memory (FeRAM) which attracts attention as a new semiconductor memory device in recent years is to read/write information actively utilizing spontaneous polarization characteristics of a ferroelectric thin film, and is expected as an excellent memory which can overcome drawbacks of previous DRAM, SRAM, FLASH memory and the like, in view of non-volatility, write speed, reliability, cell area and the like.

As a ferroelectric material for FeRAM, metal oxide materials such as lead zirconate titanate (PZT, PLZT) and bismuth layer-structure Perovskite ferroelectric (BLSF) have been proposed and studied.

Usually, as a film formation method of such a ferroelectric thin film, a physical vapor deposition method (PVD) such as a sputtering method or a chemical vapor deposition method such as a MOCVD method, or a chemical solution film formation method (solution method) has been proposed. Among them, the solution method is known to be useful to form a ferroelectric thin film most simply at the lowest cost without any special and expensive apparatus required. Further, the solution method has such advantages that the composition can easily be controlled precisely, and that a change in characteristics due to a difference in composition, which is shown in many ferroelectric materials, can be suppressed, and accordingly it is being studied as one of very useful processes for producing a ferroelectric thin film.

Preparation of a ferroelectric thin film by the solution method is a process for forming a ferroelectric thin film by coating on a substrate a solution having a metal compound (precursor) of components as a material homogeneously dissolved, drying the resulting coating film, and pre-baking the coating film as the case requires, and then baking the coating film, for example, in the air at about 700°C or higher temperature to form a thin film of a crystalline metal oxide. As a soluble metal compound as the material, an organic metal compound such as a metal alkoxide or its partial hydrolysate, or an organic acid salt or a chelate complex compound has been commonly used.

Further, with respect to a cell structure employing the above FeRAM, several cell structures have been proposed, and practically used at present is a so-called planar structure wherein a ferroelectric capacitor and a transistor are connected with local wiring, which is a structure disadvantageous from the viewpoint of reduction of the cell area i.e. high integration.

As a structure which overcomes the above drawback, a stack structure wherein a ferroelectric capacitor is formed on a plug has been proposed, but the reducing atmosphere at the time of formation of multilevel interconnection causes fatal deterioration of characteristics of the ferroelectric thin film. Further, as a structure which overcomes such problems, such a structure has been proposed that after formation of multilevel interconnection i.e. after completion of the logic process, a ferroelectric thin film and a plate line are formed on an outermost layer. In such a structure, a film is formed on a logic circuit, and accordingly the baking temperature at the time of formation of a ferroelectric thin film is required to be decreased to a level of from 400°C to 450°C.

To cope with the above, various means have been proposed to reduce the crystallization temperature also in preparation of a ferroelectric thin film by the solution method. They may, for example, be a method of appropriately controlling the structure of a precursor as shown in e.g. Japanese Patent 2967189, a method of preliminarily adding bismuth silicate as a paraelectric to a coating liquid (Ferroelectrics, vol. 271, p. 289 (2002)), a method of using a lead titanate layer as a seed layer (Jpn. J. Appl. Phys., vol. 35, p. 4,896 (1996)), selection of a proper substrate (J. Am. Ceram. Soc., vol. 75, p. 2,785 (1992)) and a vacuum annealing method (Jpn. J. Appl. Phys., vol. 38, p. 5,346 (1999)). However, reduction of the baking temperature in such conventional methods is limited to a level of 550°C.

Especially, as compared with a PZT ferroelectric material, BLSF represented by bismuth titanate is considered to make a low-voltage operation possible (Nature, vol. 401, p. 682 (1999)), and therefore, great attention has been paid on FeRAM using BLSF. However, it has been considered difficult to reduce the crystallization temperature of BLSF as compared with that of a lead ferroelectric material. Accordingly, heretofore, formation of a ferroelectric thin film on a logic circuit which is required for high integration has been considered practically difficult in a case of the solution method.

### DISCLOSURE OF THE INVENTION

### Problems That the Present Invention is to Solve

The present invention has been made to overcome the above problems of conventional technology, and it is an object of the present invention to provide a liquid composition for forming a thin film, with which, in formation of a ferroelectric thin film by a solution method, a ferroelectric thin film can be formed on a logic circuit required for high integration even when baking is carried out at a relatively low temperature, and with which a thin film having excellent ferroelectric characteristics in view of high coercive electric field characteristics and spontaneous polarization characteristics particularly fatigue characteristics, etc., can be prepared, and a process for producing a ferroelectric thin film using it.

### MEANS FOR SOLVING THE PROBLEM

The present invention is characterized by having the following construction.
(1) A liquid composition for forming a ferroelectric thin film characterized by comprising a liquid medium, crystalline ferroelectric oxide particles represented by the formula (Bi₂O₂)²⁺ (Biₘ₋₁TiₘO_{3.5m-0.5})²⁻ (wherein m is an integer of from 1 to 5) and having an average primary particle diameter of at most 100 nm, dispersed in the liquid medium, and a soluble metal compound capable of forming a ferroelectric oxide by heating, dissolved in the liquid medium.
(2) A liquid composition for forming a ferroelectric thin film characterized by comprising a liquid medium, crystalline ferroelectric oxide particles represented by the formula (Bi₂O₂)²⁺(Aₘ₋₁TiₘO_{3.5m-0.5})²⁻ (wherein A is Bi³⁺ or La³⁺, the La³⁺/Bi³⁺ ratio is from 0.05 to 0.5, and m is an integer of from 1 to 5) and having an average primary particle diameter of at most 100 nm, dispersed in the liquid medium, and a soluble metal compound capable of forming a ferroelectric oxide by heating, dissolved in the liquid medium.
(3) The liquid composition for forming a ferroelectric thin film according to the above (1) or (2), wherein in the formula, m=3.
(4) The liquid composition for forming a ferroelectric thin film according to any one of the above (1) to (3), wherein the above soluble-metal compound is a compound to form a ferroelectric oxide represented by the formula (Bi₂O₂)²⁺ (A'ₙ₋₁BₙOₓ)²⁻ (wherein A' is at least one member selected from Bi³⁺, Ba²⁺ , Sr²⁺, Ca²⁺, Pb²⁺, K⁺ and Na⁺ , B is at least one member selected from Ti⁴⁺, Nb⁵⁺, Ta⁵⁺, Mo⁶⁺, W⁶⁺ and Fe³⁺, n is an integer of from 1 to 8, and x is the number of oxygen atoms) by heating.
(5) The liquid composition for forming a ferroelectric thin film according to the above (4), wherein in the formula, A' is Bi³⁺ (provided that from 5 to 50% of Bi³⁺ may be substituted by La³⁺), and B is Ti⁴⁺, n=3, and x=10.
(6) The liquid composition for forming a ferroelectric thin film according to any one of the above (1) to (5), wherein the crystalline ferroelectric oxide particles are particles obtained by crystallizing a ferroelectric oxide in a glass matrix and then removing the glass matrix component.
(7) The liquid composition for forming a ferroelectric thin film according to any one of the above (1) to (6), wherein the content ratio of the crystalline ferroelectric oxide particles/the soluble metal compound is from 5/95 to 95/5 by the mass ratio as calculated as oxides.
(8) The liquid composition for forming a ferroelectric thin film according to any one of the above (1) to (7), wherein the total content of the crystalline ferroelectric oxide particles and the soluble-metal compound is from 1 to 50 mass%.
(9) A process for producing a ferroelectric thin film, characterized by coating the liquid composition as defined in any one of the above (1) to (8) on a substrate, followed by firing at a temperature of at most 550°C.

### EFFECT OF THE INVENTION

The present invention provides a composition for forming a thin film, with which, in formation of a bismuth ferroelectric thin film by a solution method, baking can be carried out at a relatively low temperature, particularly at a temperature of at most 550°C, or at most 500°C, whereby a ferroelectric thin film can be formed on a logic circuit required for high integration, and with which a thin film having excellent ferroelectric characteristics in view of fatigue characteristics, can be prepared, and a process for producing a ferroelectric thin film using it.

### BEST MODE FOR CARRYING OUT THE INVENTION

Now, the present invention will be described in detail.

In the present invention, crystalline ferroelectric oxide particles represented by the formula (Bi₂O₂)²⁺ (Biₘ₋₁TiₘO_{3.5m-0.5})²⁻ (wherein m is an integer of from 1 to 5) are essential components which are significant in the composition of the present invention. In the present invention, by use of a liquid composition having bismuth titanate crystal particles having such high crystallinity and having a layered Perovskite structure dispersed in a liquid medium, the baking temperature required for film formation of a bismuth ferroelectric thin film by a solution method can be drastically decreased. It is preferred that such bismuth titanate (BIT) crystal particles are ones having a compositional formula represented by Bi₄Ti₃O₁₂, i.e. m=3 in the above formula.

Further, bismuth lanthanum titanate (BLT) represented by the formula (Bi₂O₂)²⁺ (Aₘ₋₁TiₘO_{3.5m-0.5})²⁻ (wherein A is Bi³⁺ or La³⁺, the La³⁺/Bi³⁺ ratio is from 0.05 to 0.5, and m is an integer of from 1 to 5) wherein the Bi is partially substituted by La, may also be used. It is preferred that such BLT particles are ones having compositional formula corresponding to the above formula wherein m=3. Hereinafter, BIT particles and BLT particles are generally referred to simply as bismuth titanate crystal particles.

It is required that the bismuth titanate crystal particles have an average primary particle size of at most 100 nm. If the average primary particle size is larger than the above, the surface tends to be rough at the time of formation of a thin film, or the filling ratio in the thin film will not increase, whereby dielectric characteristics tend to decrease. Particularly, the average primary particle size is preferably at most 50 nm, particularly preferably from 10 to 30 nm. If the average primary particle size is less than 10 nm, the ferroelectric characteristics of the particles may decrease, such being undesirable.

The bismuth titanate crystal particles having the above characteristics are preferably particles obtained by crystallizing bismuth titanate in a glass matrix and then removing the glass matrix component, since such particles have particularly high crystallinity. That is, the particles are preferably particles obtained by a glass crystallization method wherein a component to be precipitated as ferroelectric oxide crystal particles is dissolved in a melt of a glass host material, the melt is rapidly cooled for vitrification, and heating and annealing are carried out again so that fine crystals are precipitated in the host material. The precipitated fine crystals are taken out by dissolving the glass matrix with an appropriate liquid chemical or the like.

As the glass host material, a borate type, a phosphate type or a silicate type may, for example, be used, and a borate type glass host material is preferably used in view of melt properties, easiness of production of a composite compound with an aimed oxide, easiness of elution of the matrix, etc.

Now, production of bismuth titanate crystal particles will be specifically explained. Bismuth titanate crystal particles can be obtained by the following steps (1) to (4).
(1) A glass forming component (such as boron oxide) and a metal oxide (such as bismuth oxide and titanium oxide) having a composition of aimed ferroelectric oxide are mixed, and the mixture is melted at a temperature of at least 1,200°C (melting).
(2) The molten glass is rapidly cooled to obtain glass containing metal ions of the ferroelectric oxide composition (vitrification).
(3) An annealing treatment is carried out at a temperature of a level of from 550°C to 700°C to form crystal nuclei of the ferroelectric oxide in the glass, and the annealing conditions are controlled so that the nuclei grow to a predetermined particle size (crystallization).
(4) A glass forming component (such as boron oxide) is removed by an acid, water or a mixture thereof to obtain bismuth titanate crystal particles (such as Bi₄Ti₃O₁₂,) (leaching).

By the above steps, crystallization is carried out employing glass having a very high viscosity as a host material in an annealing temperature region, whereby the particle size and the particle shape can easily be controlled, and fine particles having high crystallinity can be obtained.

The ultrafine particles crystallized in the glass matrix also have such advantages that their form can easily be controlled, fine particles having relatively high anisotropy can easily be prepared depending upon e.g. conditions of the annealing treatment, and particles having a high aspect ratio can easily be obtained.

Further, in the present invention, the soluble metal compound to form a ferroelectric oxide by heating (hereinafter sometimes referred to simply as a soluble metal compound) is a compound which can be converted into an oxide by e.g. thermal decomposition by heating to show ferroelectric properties. In a case where the aimed ferroelectric oxide is a composite oxide, two or more soluble metal compounds are mixed in a predetermined ratio, or a composite metal compound containing two or more metals in a predetermined ratio is used. Such a soluble metal compound may, for example, be an inorganic acid salt such as a nitrate, an organic acid salt such as an ethylhexanoate, an organic metal complex such as an acetylacetone complex, or a metal alkoxide, and it is particularly preferably an organic acid salt, an organic metal complex or a metal alkoxide.

In the procedure for forming the ferroelectric thin film from the liquid composition for forming a ferroelectric thin film of the present invention, the soluble metal compound functions also as a binder of the bismuth titanate crystal particles, and it is possible that the soluble metal compound undergoes crystal growth employing the above-described bismuth titanate crystal particles as nuclei, whereby crystallization at a lower temperature becomes possible. Further, the soluble metal compound also has a function to improve dielectric characteristics of the obtained ferroelectric thin film as a whole, by forming a ferroelectric oxide in a space between the bismuth titanate crystal particles after baking by a heat treatment.

The soluble metal compound may have a composition to form a ferroelectric having substantially the same composition as the bismuth titanate crystal particles after baking, or may have a composition to form a ferroelectric having a composition different from the bismuth titanate crystal particles. Specifically, the above soluble-metal compound is preferably a compound to form a ferroelectric oxide represented by the formula (Bi₂O₂)²⁺ (A'ₙ₋₁BₙOₓ)²⁻ (wherein A' is at least one member selected from Bi³⁺, Ba²⁺, Sr²⁺, Ca²⁺, Pb²⁺, K⁺ and Na⁺, B is at least one member selected from Ti⁴⁺, Nb⁵⁺, Ta⁵⁺, Mo⁶⁺, W⁶⁺ and Fe³⁺, n is an integer of from 1 to 8, and x is the number of oxygen atoms) by heating of the liquid composition and having a layered Perovskite structure.

However, considering that the bismuth titanate crystal particles function as crystal nuclei, such a compound is preferably a compound to form a ferroelectric having the same composition as far as possible as the bismuth titanate crystal particles. In the formula, it is particularly preferred that A' is Bi³⁺ (provided that from 5 to 50% of Bi³⁺ may be substituted by La³⁺), and B is Ti⁴⁺, n=3, and x=10.

In the present invention, the content ratio of the bismuth titanate crystal particles to the soluble metal compound is preferably from 5/95 to 95/5 by the mass ratio calculated as oxides when the soluble metal compound is converted into an oxide by heating. If the content ratio of the bismuth titanate crystal particles is higher than this range, the binder component tends to be insufficient, and the formed thin film may not adhere to the substrate. On the other hand, if it is lower than the above range, the effect of addition of the bismuth titanate crystal particles is less likely to be obtained. The above ratio is particularly preferably from 30/70 to 70/30.

The bismuth titanate crystal particles and the soluble metal compound are used as a liquid composition comprising the bismuth titanate crystal particles dispersed and the soluble metal compound dissolved in an appropriate liquid medium, for e.g. a coating liquid for forming a ferroelectric thin film. When the above liquid composition is to be formed, the bismuth titanate crystal particles and the soluble metal compound may be mixed and then dissolved or dispersed in a liquid medium, or they may be dispersed or dissolved in the same or different liquid media and then mixed.

The liquid medium is not particularly limited so long as it is capable of dissolving the soluble metal compound, and it is usually water, an alcohol (such as ethanol or 2-propanol), an ether alcohol (such as 2-ethoxyethanol or 2-ethoxypropanol), an ester (such as butyl acetate or ethyl lactate), a ketone (such as acetone or methyl isobutyl ketone), an ether (such as dibutyl ether or dioxane), an aliphatic hydrocarbon (such as cyclohexane or decane), an aromatic hydrocarbon (toluene or xylene), a nitrogen-containing organic solvent (such as acetonitrile or N-methylpyrrolidone) or a mixed solvent of two or more thereof. As a specific liquid medium, such solvents may be properly selected and mixed depending upon the type and the surface state of the crystal particles in the composition, the type of the soluble metal compound and the coating method. An undissolved soluble metal compound may be partially contained in the liquid medium.

The content of solid matter (the total of the bismuth titanate crystal particles and the soluble metal compound) in the liquid composition of the present invention is appropriately adjusted depending upon the aimed ferroelectric film thickness, the coating method of the liquid composition or the like, and is usually preferably from 1 to 50 mass%. If such content of solid matter is lower than the above range, the thin film obtained by coating tends to be very thin, whereby coating has to be repeatedly carried out many times to obtain a desired thickness, and if it is higher than the above range, the stability of the liquid may decrease.

When the bismuth titanate crystal particles and the soluble metal compound forming the liquid composition of the present invention are dissolved or dispersed in a medium, known method and apparatus can be used, such as a media mill such as a bead mill or a sand mill, a homogenizer of an ultrasonic type, a stirring type or the like, or a jet mill or a roll mill.

In the liquid composition of the present invention, a dispersing agent to disperse the bismuth titanate crystal particles or the soluble metal compound, a surfactant or a surface treating agent to improve rheological characteristics of the coating film, a resin component or the like may be incorporated. However, if they are added in a large amount, they tend to remain as a residual carbon content after baking, and accordingly they are added preferably in a minimum amount required.

The liquid composition of the present invention is coated on a substrate and baked to produce the ferroelectric thin film. As a coating method, a known method may be employed. As specific preferred examples, a spin coating method, a dip coating method, a spray coating method, a screen printing method and a transfer printing method may, for example, be mentioned. Among them, a spin coating method is most preferably used in view of productivity and homogeneity of the obtained thin film.

The substrate used for formation of the thin film in the present invention may, for example, be a single crystal semiconductor substrate of e.g. Si or GaAs, a single crystal dielectric substrate of e.g. BaTiO₃, SrTiO₃, MgO or Al₂O₃, one having on a surface thereof polycrystal Si or as an electrode layer, Pt, Ir, IrO₂, Ru, RuO₂ or the like deposited, or one comprising an insulating layer of e.g. SiO₂ or Si₃N₄ or a buffer layer of e.g. Ti or Ta provided between a semiconductor substrate and the above electrode layer. However, the substrate is not limited thereto so long as it has heat resistance to a level of the baking temperature.

The liquid composition of the present invention is coated on such a substrate, and preferably, the liquid composition is dried usually at from 100 to 400°C for from 1 minute to 2 hours to remove the liquid medium, and then baking is carried out at 300°C or more. The baking, in the present invention as mentioned above, can be carried out at a low temperature, and it is carried out preferably at a temperature of at most 550°C, or at most 500°C in some cases. Needless to say, the baking may be carried out at a temperature higher than 550°C, and baking at such a high temperature may be advantageous depending upon the purpose of use in some cases. The baking time varies depending upon the temperature or the atmosphere, and is preferably from 1 minute to 2 hours. This baking is to decompose and/or crystallize the soluble metal compound, and it may be carried out in an atmosphere such as in the air, in oxygen or in an inert gas, and the atmosphere may appropriately be selected. For the baking, a usual electric furnace such as a diffusion furnace may be used, but a hot plate or an infrared lamp annealing furnace (RTA) with which rapid heating is possible is preferred, since crystallization is more likely to progress.

When the ferroelectric thin film is formed in the present invention as mentioned above, if desired film thickness cannot be achieved by a single process comprising coating, drying and baking, needless to say, this process can be carried out repeatedly.

### EXAMPLES

Now, the present invention will be explained in further detail with reference to Examples. However, the present invention is by no means restricted to the following Examples. Examples 6 to 8 are Comparative

### Examples.

### EXAMPLE 1 Preparation of bismuth titanate crystal particles (BIT)

Boron oxide, bismuth oxide and titanium oxide (rutile) were weighed in amounts of 50.0 mol%, 38.0 mol% and 12.0 mol% as B₂O₃, Bi₂O₃ and TiO₂, respectively, and they were subjected to thorough wet mixing in an automatic mortar using a small amount of ethanol and then dried to obtain a material powder. The obtained material powder was packed in a platinum container (containing 10% of rhodium) equipped with a nozzle for dropping a melt, heated in an electric furnace employing molybdenum silicate as a heating element at 1,350°C for 2 hours and completely melted. Then, the nozzle portion was heated and the melt was dropped on a twin roll (roll diameter: 150 mm, number of revolutions of roll: 50 rpm, roll surface temperature: 30°C) disposed below the electric furnace to obtain a flaky solid.

The obtained flaky solid was transparent and as a result of powder X-ray diffraction, confirmed to be an amorphous substance. The obtained flaky solid was heated at 550°C for 8 hours to precipitate bismuth titanate crystal in a B₂O₃ glass matrix. Then, such an obtained flaky powder was added in a 1 mol/L aqueous acetic acid solution kept at 80°C and stirred for 6 hours and then, subjected to centrifugal separation, washed with water and dried to obtain a white powder.

The obtained white powder was identified by powder X-ray diffraction and as a result, it was found to be a powder consisting of bismuth titanate crystals (Bi₄Ti₃O₁₂) alone. Further, as a result of observation by a transmission electron microscope, the crystals had a diameter of 30 nm.

### EXAMPLE 2 Preparation of ferroelectric thin film

The BIT crystal particles obtained in Example 1 are dispersed in ethanol by using a wet jet mill and subjected to centrifugal separation to remove coarse particles, whereby a dispersion A containing 10 mass% of BIT is obtained. The dispersed particle size of the dispersion A is measured by using a laser scattering particles size distribution meter and as a result, it is 90 nm, and the dispersion A is a favorable dispersion.

Bismuth ethylhexanoate (toluene solution) and titanium tetrabutoxide are added to a butanol/ethanol mixed solvent (50/50 volume%) in a metal abundance ratio of Bi:Ti=4.2:3.0 and dissolved therein, and reflux with heating is carried out in a stream of nitrogen at 80°C for 12 hours to obtain a soluble metal compound solution B. The amount of solvent is adjusted so as to be 10 mass% as BIT after crystallization.

Then, the dispersion A and the soluble metal compound solution B are mixed in a mass ratio of 50/50 to obtain a coating composition of the present invention.

Using as a substrate a silicon single crystal substrate having Pt (200 nm)/Ti (20 nm)/thermal-oxidized SiO₂ (800 nm) laminated on its surface, the above coating composition is coated on the Pt by a spin coating method and dried on a hot plate at 200°C for 30 minutes. This treatment comprising coating and drying is carried out three times and then a heat treatment is carried out by using a RTA furnace in oxygen at 500°C for 15 minutes.

The obtained coating film has a thickness of 100 nm, and as a result of X-ray diffraction, it is a coating film consisting of a BIT crystalline phase alone. Further, a Pt electrode of 0.1 mm in diameter is prepared on this coating film by a DC sputtering method, and a post-annealing treatment is carried out in a RTA furnace at 500°C for 5 minutes to prepare a capacitor, and ferroelectric hysteresis characteristics are measured. As a result, the coercive electric field is 32 kV/cm at the application of 3V and the spontaneous polarization is 5.6 µC/cm². Fatigue characteristics of the obtained ferroelectric capacitor are evaluated and as a result, the change in the spontaneous polarization is suppressed to be within 5% even after 10⁸ cycles at 3 V.

### EXAMPLE 3 Preparation of ferroelectric thin film

Strontium metal, bismuth ethylhexanoate (toluene solution) and tantalum pentaethoxide were dissolved in a dehydrated 2-methoxyetanol in a metal abundance ratio of Sr:Ti:Ta=1.0:2.1:2.0. The solution concentration is adjusted to 10 mass% as an SBT (strontium-bismuthtantalum) oxide and the soluble metal compound solution C is prepared.

Then, the dispersion A and the soluble metal compound solution C are mixed in a mass ratio of 20/80 to obtain a coating composition of the present invention.

The coating composition is subjected to a treatment comprising coating, drying and baking on a silicon substrate having Pt (200 nm)/Ti (20 nm)/thermal-oxidized SiO₂ (500 nm) laminated on its surface to obtain a coating film made of BIT-SBT.

The obtained coating film has a thickness of 110 nm, and as a result of X-ray diffraction, it is a coating film consisting of a BIT and SBT crystalline phases alone. Further, a Pt electrode of 0.1 mm in diameter is prepared on this coating film by a DC sputtering method, and a post-annealing treatment is carried out in a RTA furnace at 500°C for 5 minutes to prepare a capacitor, and ferroelectric hysteresis characteristics are measured. As a result, the coercive electric field is 31 kV/cm when 3V is applied and the spontaneous polarization is 5.5 µC/cm². Fatigue characteristics of the obtained ferroelectric capacitor are evaluated, and the change in the spontaneous polarization is suppressed to be within 5% even after 10⁸ cycles at 3 V.

### EXAMPLES 4 to 6 (Example 6 is Comparative Example)

A ferroelectric thin film is prepared in the same manner as in Example 2 by changing the mixture ratio of the dispersion A of Example 2 and the soluble metal compound solution B to be in a ratio as shown in Table 1, and evaluation is carried out.

### EXAMPLE 7 (Comparative Example)

Film formation and evaluation are carried out in the same manner as in Example 2 by using, instead of the dispersion A of Example 2, a dispersion D containing 10 mass% of spherical BIT crystal particles having an average primary particle size of 1.2 µm prepared by a solid phase method. The obtained phase is a ferroelectric phase comprising a BIT single phase, and the polarization characteristics are equal to those of the coating film obtained in Example 2. However, as a result of evaluation of fatigue characteristics, the spontaneous polarization becomes substantially 0 after 10⁶ cycles at 3 V, and deterioration is remarkable. Evaluation

Film formation conditions of a ferroelectric thin film in Examples 2 to 7, is shown in Table 1, and dielectric characteristics and fatigue characteristics of the ferroelectric thin film obtained in Examples 2 to 7, is shown in Table 2. Further, in Table 2, such fatigue characteristics show number of cycles when the spontaneous polarization decreases by 5% or more of the initial value.

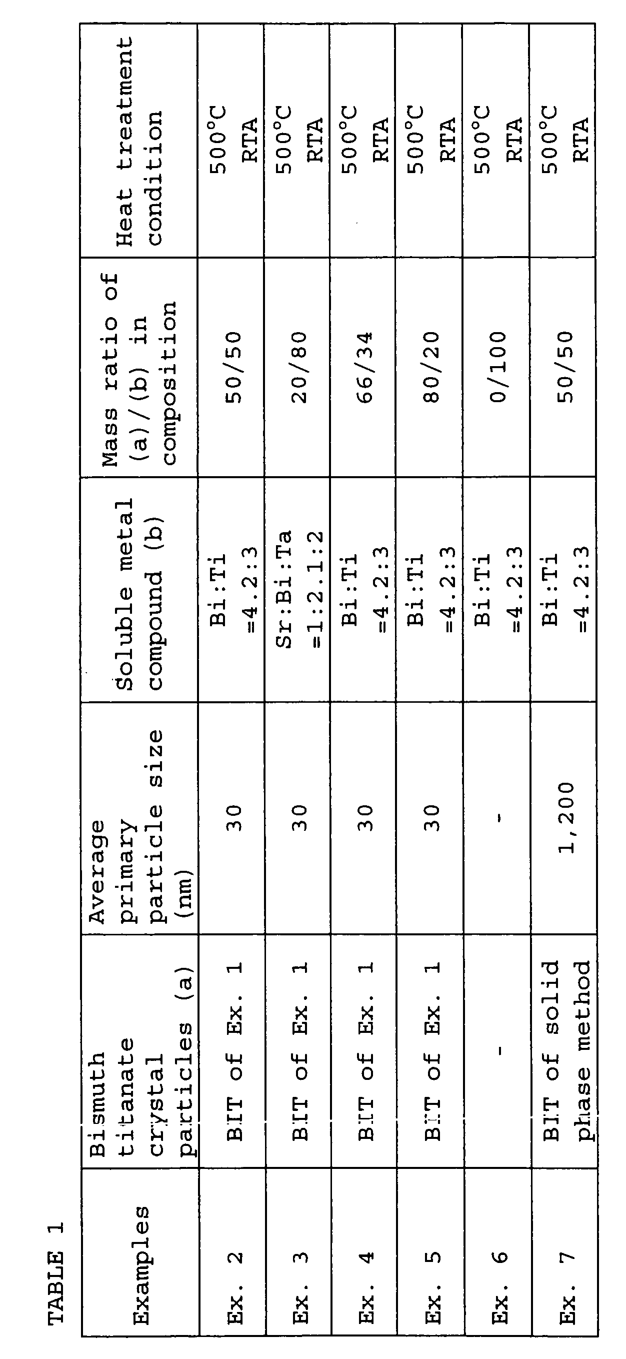

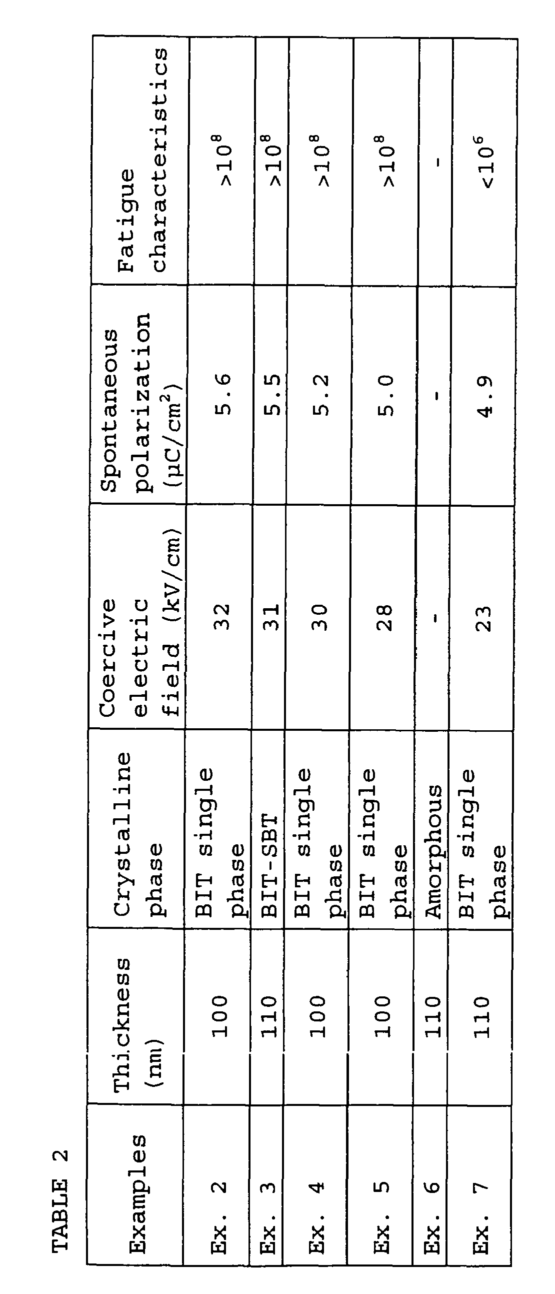

### INDUSTRIAL APPLICABILITY

The ferroelectric thin film of the present invention is useful for production of semiconductor devices and other devices.

## Claims

1. A liquid composition for forming a ferroelectric thin film **characterized by** comprising a liquid medium, crystalline ferroelectric oxide particles represented by the formula (Bi₂O₂)²⁺ (Biₘ₋₁TiₘO_{3.5m-0.5})²⁻ (wherein m is an integer of from 1 to 5) and having an average primary particle diameter of at most 100 nm, dispersed in the liquid medium, and a soluble metal compound capable of forming a ferroelectric oxide by heating, dissolved in the liquid medium.

2. A liquid composition for forming a ferroelectric thin film **characterized by** comprising a liquid medium, crystalline ferroelectric oxide particles represented by the formula (Bi₂O₂)²⁺ (Aₘ₋₁TiₘO_{3-5m-0.5})²⁻ (wherein A is Bi³⁺ or La³⁺, the La³⁺/B i³⁺ ratio is from 0.05 to 0.5, and m is an integer of from 1 to 5) and having an average primary particle diameter of at most 100 nm, dispersed in the liquid medium, and a soluble metal compound capable of forming a ferroelectric oxide by heating, dissolved in the liquid medium.

3. The liquid composition for forming a ferroelectric thin film according to Claim 1 or 2, wherein in the formula, m=3.

4. The liquid composition for forming a ferroelectric thin film according to any one of Claims 1 to 3, wherein the above soluble-metal compound is a compound to form a ferroelectric oxide represented by the formula (Bi₂O₂)²⁺(A'ₙ₋₁BₙOₓ)²⁻ (wherein A' is at least one member selected from Bi³⁺, La³⁺, Ba²⁺, Sr²⁺, Ca²⁺, Pb²⁺, K⁺ and Na⁺, B is at least one member selected from Ti⁴⁺, Nb⁵⁺, Ta⁵⁺, Mo⁶⁺, W⁶⁺ and Fe³⁺, n is an integer of from 1 to 8, and x is the number of oxygen atoms) by heating of the liquid composition.

5. The liquid composition for forming a ferroelectric thin film according to Claim 4, wherein in the formula, A' is Bi³⁺ (provided that from 5 to 50% of Bi³⁺ may be substituted by La³⁺), and B is Ti⁴⁺, n=3, and x=10.

6. The liquid composition for forming a ferroelectric thin film according to any one of Claims 1 to 5, wherein the crystalline ferroelectric oxide particles are particles obtained by crystallizing a ferroelectric oxide in a glass matrix and then removing the glass matrix component.

7. The liquid composition for forming a ferroelectric thin film according to any one of Claims 1 to 6, wherein the content ratio of the crystalline ferroelectric oxide particles/the soluble metal compound is from 5/95 to 95/5 by the mass ratio as calculated as oxides.

8. The liquid composition for forming a ferroelectric thin film according to any one of Claims 1 to 7, wherein the total content of the crystalline ferroelectric oxide particles and the soluble-metal compound is from 1 to 50 mass%.

9. A process for producing a ferroelectric thin film, **characterized by** coating the liquid composition as defined in any one of Claims 1 to 8 on a substrate, followed by firing at a temperature of at most 550°C.
